# EUROPÄISCHE PATENTSCHRIFT

(11) **EP 0 370 355 B1**
(45) Veröffentlichungstag und Bekanntmachung des Hinweises auf die Patenterteilung: **29.09.1993**
(21) Anmeldenummer: 89120998.3
(22) Anmeldetag: 13.11.1989
(51) Int. Cl.: G03F 7/033

(54) **Durch Strahlung polymerisierbares Gemisch und daraus hergestelltes Aufzeichnungsmaterial**
Radiation-polymerisable mixture, and registration material prepared thereof
Mélange polymérisable par les radiations et matériau pour l'enregistrement préparé à partir de ce mélange

(30) Priorität: 22.11.1988 DE 3839366
(43) Veröffentlichungstag der Anmeldung: 30.05.1990
(73) Patentinhaber: HOECHST AKTIENGESELLSCHAFT, 65926 Frankfurt am Main (DE)
(72) Erfinder: Schneller, Arnold, Dr., D-6500 Mainz 21 (DE); Emmelius, Michael, Dr., D-6500 Mainz-Bretzenheim (DE)

(56) Entgegenhaltungen:
- EP-A- 0 135 900
- EP-A- 0 212 440
- US-A- 4 239 849

## Beschreibung

Die Erfindung betrifft ein durch Strahlung, insbesondere ultraviolettes oder sichtbares Licht, polymerisierbares Gemisch, das für die Herstellung von Photoresistschablonen und Druckplatten geeignet ist, sowie ein Aufzeichnungsmaterial aus einem Schichtträger und einer strahlungsempfindlichen Schicht, die aus dem genannten Gemisch besteht.

Gemische der angegebenen Gattung sind bekannt. Sie enthalten im allgemeinen ein polymeres Bindemittel, eine radikalisch polymerisierbare Verbindung und einen durch Strahlung, insbesondere Licht, aktivierbaren Polymerisationsinitiator. Als Bindemittel werden vorzugsweise solche Polymeren eingesetzt, die wasserunlöslich und in wäßrig-alkalischen Lösungen sowie in organischen Lösemitteln löslich sind. In der überwiegenden Mehrzahl werden als Bindemittel Copolymere der Acryl- oder Methacrylsäure mit neutralen Monomeren, z. B. (Meth)acrylsäureestern, Styrol, (Meth)acrylnitril und dgl., gewählt. Derartige Gemische sind z. B., in den DE-A 20 64 080 und 23 63 806 und den EP-A 141 921 und 173 057 beschrieben. Diese Gemische eignen sich besonders gut für Druckplatten und Trockenphotoresistmaterialien, bei denen nur eine begrenzte Auflösung erforderlich ist. Die Wiedergabe von Bildelementen höherer Auflösung bereitet jedoch mit den bekannten Gemischen Schwierigkeiten, so daß ein gewisses Maß an Auflösung nicht ohne Gefahr von Kopierfehlern unterschritten werden kann.

Es wurde vermutet, daß die geringe Auflösung durch die Natur der normalerweise eingesetzten negativ arbeitenden lichtempfindlichen Systeme, insbesondere der photopolymerisierbaren Gemische oder der photovernetzbaren Polymeren bedingt war.

In der EP-A 135 900 wird ein negativ arbeitendes lichtempfindliches Gemisch mit verbesserter Auflösung beschrieben, das aus Arylaziden und einer Kombination von bestimmten hochmolekularen Phenolharzen und Novolaken als Bindemittel besteht. Als hochmolekulare Phenolharze werden u. a. Polyvinylphenole eingesetzt. Diese Gemische sind relativ wenig lichtempfindlich, und die damit erhaltenen Schichten sind - insbesondere im belichteten Zustand - ziemlich spröde.

In den EP-A 212 439 und 212 440 sind positiv arbeitende lichtempfindliche Gemische beschrieben, die als Bindemittel Polymere mit seitenständigen phenolischen Gruppen, z. B. Polymere mit Einheiten aus Resorcinmonomethacrylat, enthalten. Diese Schichten weisen eine geringere Sprödigkeit als solche mit Novolaken als Bindemittel auf. Dies gilt natürlich nur für die unbelichteten Schichten, die beim Positivprozeß als Bildschablone nach dem Entwickeln zurückbleiben. Die Herstellung negativ arbeitender Materialien wird hier nicht erwähnt.

Aufgabe der Erfindung war es, ein durch Strahlung, insbesondere Licht polymerisierbares Gemisch vorzuschlagen, das zur Herstellung von Druckplatten und Trockenphotoresistmaterialien geeignet ist, das sich leicht in wäßrig-alkalischen Lösungen entwickeln läßt, Schichten mit hoher Flexibilität bildet und eine bessere Auflösung ergibt als bekannte photopolymerisierbare Gemische.

Gegenstand der Erfindung ist ein durch Strahlung polymerisierbares Gemisch, das als wesentliche Bestandteile
a) ein in Wasser unlösliches, in wäßrig-alkalischen Lösungen lösliches polymeres Bindemittel,
b) eine radikalisch polymerisierbare Verbindung mit mindestens einer endständigen ethylenischen Doppelbindung und einem Siedepunkt oberhalb 100° C bei Normaldruck und
c) eine Verbindung oder eine Verbindungskombination enthält, die unter Einwirkung von aktinischer Strahlung die Polymerisation der Verbindung (b) zu initiieren vermag.

Das erfindungsgemäße Gemisch ist dadurch gekennzeichnet, daß das Bindemittel ein Polymeres mit wiederkehrenden Einheiten der allgemeinen Formel I 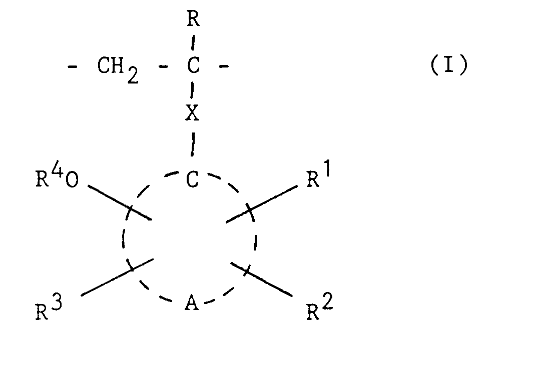
ist, worin
- R: ein Wasserstoff- oder Halogenatom, eine Cyanogruppe oder eine Alkylgruppe mit 1-4 Kohlenstoffatomen ist,
- R¹ , R² und R³: gleich oder verschieden sind und Wasserstoff-oder Halogenatome, Alkyl-, Alkoxy-, Alkoxycarbonyl-, Acyl-, Aryloxy-, Aroyl-, Hydroxy-oder Aralkylgruppen bedeuten,
- R⁴: ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I R⁴ ein Wasserstoffatom ist,
- X: eine kovalente Bindung, ein Sauerstoffatom oder eine der Gruppen COO, CONR⁸, COOCH₂CHOHCH₂OCO, COOCH₂CH₂O und COOCH₂CH₂OCO ist, worin R⁸ ein Wasserstoffatom, eine Alkyl-oder Arylgruppe bedeutet, und
- A: die zur Vervollständigung eines ein- oder zweikernigen carbo- oder heterocyclischen aromatischen Ringsystems erforderlichen Atome bedeutet.

Erfindungsgemäß wie ferner ein durch Strahlung polymerisierbares Aufzeichnungsmaterial mit einem flexiblen, transparenten temporären Schichtträger und einer übertragbaren, thermoplastischen, durch Strahlung polymerisierbaren Photoresistschicht, die als wesentliche Bestandteile
a) ein in Wasser unlösliches, in wäßrig-alkalischen Lösungen lösliches polymeres Bindemittel,
b) eine radikalisch polymerisierbare Verbindung mit mindestens einer endständigen ethylenischen Doppelbindung und einem Siedepunkt oberhalb 100° C bei Normaldruck und
c) eine Verbindung oder eine Verbindungskombination enthält, die unter Einwirkung von aktinischer Strahlung die Polymerisation der Verbindung (b) zu initiieren vermag,
und gegebenenfalls einem Deckblatt auf der freien Seite der Photoresistschicht vorgeschlagen, das an dieser Schicht weniger stark haftet als der temporäre Schichtträger.

Das erfindungsgemäße Aufzeichnungsmaterial ist dadurch gekennzeichnet, daß das Bindemittel ein Polymeres mit wiederkehrenden Einheiten der allgemeinen Formel I 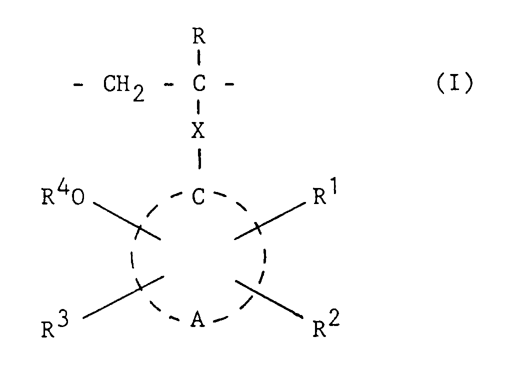
ist, worin
- R: ein Wasserstoff- oder Halogenatom, eine Cyanogruppe oder eine Alkylgruppe mit 1-4 Kohlenstoffatomen ist,
- R¹, R² und R³: gleich oder verschieden sind und Wasserstoff-oder Halogenatome, Alkyl-, Alkoxy-, Alkoxycarbonyl-, Acyl-, Aryloxy-, Aroyl-,Hydroxy-oder Aralkylgruppen bedeuten,
- R⁴: ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I R⁴ ein Wasserstoffatom ist,
- X: eine kovalente Bindung, ein Sauerstoffatom oder eine der Gruppen COO, CONR⁸, COOCH₂CHOHCH₂OCO, COOCH₂CH₂O und COOCH₂CH₂OCO ist, worin R⁸ ein Wasserstoffatom, eine Alkyl-oder Arylgruppe bedeutet, und
- A: die zur Vervollständigung eines ein- oder zweikernigen carbo- oder heterocyclischen aromatischen Ringsystems erforderlichen Atome bedeutet.

Das Polymere der Formel I kann ein Homopolymeres oder ein Copolymeres sein, das neben Einheiten der Formel I andere von copolymerisierbaren ethylenisch ungesättigten Monomeren abgeleitete Einheiten enthält. Die Comonomeren sind im allgemeinen Monovinylverbindungen. Sie können auch vernetzungsfähige Gruppen, z. B. Epoxygruppen, N-Methylol- oder N-Methoxymethylgruppen, enthalten, die sich katalytisch oder thermisch vernetzen lassen. Die Vernetzung kann zur Härtung der Bildschablone nach dem Entwickeln, vorzugsweise durch Erhitzen, vorgenommen werden.

Wenn in der Formel I R eine Alkylgruppe ist, enthält diese im allgemeinen 1 bis 6, bevorzugt 1 oder 2 Kohlenstoffatome. Besonders bevorzugt werden Verbindungen mit R = H oder Methyl.

Von den Substituenten R¹, R² und R³ ist bevorzugt mindestens einer ein Wasserstoffatom, besonders bevorzugt sind mindestens zwei davon Wasserstoffatome. Wenn diese Symbole Alkyl- oder Alkoxygruppen bedeuten, haben diese bevorzugt 1 bis 6, insbesondere 1 bis 3 Kohlenstoffatome.

Allgemein sind hier unter Alkylgruppen verzweigte und unverzweigte, gesättigte und ungesättigte Gruppen mit cyclischen und offenen Ketten zu verstehen, die durch Halogenatome oder Hydroxygruppen substituiert sein oder Ether- oder Ketogruppen enthalten können. Bevorzugt werden unverzweigte Kohlenwasserstoffreste mit 1 bis 3 Kohlenstoffatomen.

X ist bevorzugt eine kovalente Bindung oder eine Gruppe COO.

Wenn das aromatische Ringsystem A heterocyclisch ist, kann es z. B. ein Pyridin-, Pyrimidin-, Pyrazin-, Chinolin-, Isochinolin-, Chinoxalin-, Indol- oder Thiophensystem sein. Als aromatische Ringsysteme kommen Benzol, Naphthalin und Biphenyl in Betracht; besonders bevorzugt wird ein Benzolring.

Die Stellung der Gruppen OR⁴ unterliegt keinerlei Beschränkungen; sie richtet sich nach der präparativen Zugänglichkeit. Die Stellung der Reste R¹, R² und R³ richtet sich nach der Stellung der Gruppen OR⁴.

Wenn R⁴ eine zweiwertige Gruppe ist, liegt diese im Polymeren in solchem Mengenanteil vor, daß die Löslichkeit des Produkts nicht beeinträchtigt wird. Im allgemeinen enthalten nicht mehr als 20 mol-%, vorzugsweise nicht mehr als 10 mol-% der Einheiten der Formel I eine Gruppe R⁴O, in der R⁴ von H verschieden ist. R⁴ kann in diesem Falle eine aromatische oder aliphatische Gruppe sein, die vorzugsweise 2 bis 15 Kohlenstoffatome enthält und z. B. durch Umsetzen eines Diepoxids oder Diisocyanats mit OH-Gruppen entstanden ist. Dabei werden als Reaktionspartner Diisocyanate bevorzugt. Beispiele für geeignete Diisocyanate sind Tolylen-, Hexamethylen-, 2,2,4-Trimethylhexamethylen-, Lysin-, Isophoron- und Diphenylmethandiisocyanat.

Beispiele für geeignete Einheiten der Formel I sind solche aus o-, m- und p-Hydroxystyrol, o-, m- und p-Isopropenylbenzol, Monoacrylaten oder -methacrylaten oder Monovinylethern des Hydrochinons, Brenzcatechins, Resorcins, des Methyl- oder Chlorresorcins, Ethylhydrochinons, 2,3-Dihydroxy-naphthalins, 4,4′-Dihydroxy-biphenyls, 2,2-Bis-(4-hydroxyphenyl)propans, 5,8-Dihydroxy-chinolins, des Salicylsäure-ß-hydroxyethylesters, 2-Hydroxy-3-naphthoesäure-ß-hydroxyethylesters, des 4-Chlor- oder 4-Brom-salicylsäure-2,3-dihydroxypropylesters, des 4,4′-Dihydroxybenzophenons oder des 2,4-Dihydroxy-acetophenons, des Pyrogallols, Phloroglucins, Hydroxyhydrochinons, des 3,4,5-Trihydroxy-benzoesäureethylesters, des 2,3,4-Trihydroxytoluols, des 3,3′,4,4′-Tetrahydroxybiphenyls oder eines Trihydroxychinolins. Weitere Beispiele sind Einheiten aus (Meth)acrylsäureamiden des o-, m- oder p-Aminophenols oder des 1-Amino-naphthols-(7). Die Monomeren, die Einheiten der Formel I bilden, sind bekannt und z. B. in den EP-A 212 439 und 212 440 beschrieben. Auch ihre Umsetzung zu Polymeren ist dort beschrieben.

Die Polymeren mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, gegebenenfalls auch solchen mit phenolischen Gruppen, sein. Weiterhin können verschiedene Monomere entsprechend Formel I miteinander, gegebenenfalls auch mit weiteren Vinylmonomeren, copolymerisiert werden.

Das Molekulargewicht der Homo- bzw. Copolymeren kann in weiten Grenzen variiert werden; bevorzugt werden Polymerisate mit M̅ₙ = 1000 - 200.000, besonders solche mit M̅ₙ = 5000 - 100.000. Die Hydroxylzahl liegt im allgemeinen im Bereich von 100 bis etwa 450, vorzugsweise zwischen 200 und 350.

Die Auswahl von geeigneten Homo- und Copolymeren richtet sich im Einzelfall nach dem Anwendungszweck und nach der Art der übrigen Komponenten in dem strahlungs- bzw. lichtempfindlichen Gemisch. So ist die Hydrophilie des Bindemittels eines lichtempfindlichen Gemischs von Bedeutung für die Lichtempfindlichkeit, Entwicklungszeit und Entwicklerresistenz. Die Hydrophilie muß daher an das jeweilige lichtempfindliche Gemisch angepaßt werden.

Wichtig für die anwendungstechnischen Eigenschaften eines lichtempfindlichen Gemischs ist weiterhin seine Erweichungstemperatur, die wesentlich durch die des Bindemittels bestimmt wird. Das erfindungsgemäße Gemisch eröffnet die Möglichkeit, die genannten Eigenschaften z. B. durch Wahl der Substituenten am Aromaten oder vor allem durch die Wahl der Comonomeren, gezielt zu variieren und auf die jeweiligen Anforderungen maßzuschneidern.

Als Comonomere für die Verbindungen, die zu Einheiten der Formel I polymerisieren, werden Verbindungen der allgemeinen Formel 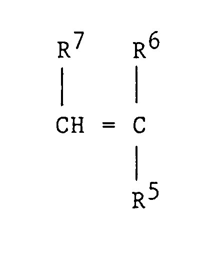
bevorzugt, worin
- R⁵: ein Wasserstoff- oder Halogenatom oder eine Alkylgruppe,
- R⁶: eine Alkyl-, Alkoxy-, Alkyloxycarbonyl-, Acyl-, Acyloxy-, Aryl-, Formyl-, Cyano-, Carboxyl-, Hydroxy- oder Aminocarbonylgruppe und
- R⁷: ein Wasserstoffatom oder eine Carboxylgruppe ist, die mit R⁶, wenn dieses eine Carboxylgruppe ist, zu einem Säureanhydrid verbunden sein kann.

Wenn R⁵ oder R⁶ Alkylgruppen sind, haben diese im allgemeinen 1 - 4 Kohlenstoffatome. Als Vertreter für R⁶ kommen in Betracht: Alkoxygruppen mit 1 - 8 C-Atomen, Alkyloxycarbonylgruppen mit 2 - 13 C-Atomen, Acylgruppen mit 2 - 20 C-Atomen, Acyloxygruppen mit 2 - 5 C-Atomen und Arylgruppen mit 6 - 10 C-Atomen. Die Aminocarbonylgruppen können unsubstituiert oder durch eine oder zwei Alkylgruppen mit 1 - 8 C-Atomen substituiert sein. Die Alkylgruppen haben die oben angegebene Bedeutung.

Beispiele für solche Verbindungen sind Styrol, 1-Chlorvinyl-benzol, Propen-2-yl-benzol, 2-, 3- oder 4-Chlormethyl-styrol, 4-Brom-styrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Decyl-, Dodecyl-, 2-Ethylhexyl-, Phenyl-, Benzyl-, Biphenylyl- und Naphthylester dieser Säuren, Methacrylamid, Acrylamid, Vinylacetat, Vinylisobutylketon und Maleinsäureanhydrid.

Der Gehalt an Einheiten der Formel I im Copolymeren richtet sich nach den übrigen Komponenten des Gemischs und nach der Anwendung. Im allgemeinen werden im erfindungsgemäßen Gemisch Polymere mit einem Gehalt von 20 bis 100 mol-%, vorzugsweise 40 bis 100 mol-% an Einheiten der Formel I eingesetzt.

Zur Herstellung der erfindungsgemäßen Gemische wird das beschriebene Bindemittel kombiniert mit Photoinitiatoren und polymerisationsfähigen Verbindungen. Als polymerisierbare Monomere kommen Verbindungen mit mindestens einer ungesättigten Doppelbindung in Betracht. Als Beispiele für monofunktionelle Verbindungen sind langkettige substituierte und unsubstituierte Alkyl-oder Alkoxyalkylester der Methacrylsäure und Acrylsäure zu nennen, wie sie beispielsweise in der EP-A 128 014 beschrieben sind. Weiterhin lassen sich vorteilhaft Monomere mit Urethangruppen einsetzen. Beispiele dafür finden sich in der DE-A 35 40 480.

Die erfindungsgemäßen Gemische enthalten vorzugsweise mindestens zum Teil polymerisierbare Verbindungen mit mindestens zwei endständigen ethylenischen Doppelbindungen. Als derartige polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1.000, Neopentylglykol, Trimethylolethan und -propan, Pentaerythrit und oxyethylierte Bisphenol-A-Derivate. Besonders geeignet sind Urethangruppen enthaltende Bisacrylate und Bismethacrylate, die durch Umsetzung von 1 mol eines Diols mit 2 mol eines Diisocyanats und 2 mol Hydroxyalkylacrylat oder -methacrylat erhalten werden. Derartige Urethangruppen enthaltende Monomere sind in der DE-A 28 22 190 beschrieben. Ähnliche Monomere sind in der DE-A 30 48 502 beschrieben.

Als durch Strahlung, insbesondere aktinisches Licht aktivierbare Polymerisationsinitiatoren in dem erfindungsgemäßen Gemisch können eine Vielzahl von Substanzen Verwendung finden. Beispiele sind Benzoin und seine Derivate, Trichlormethyl-s-triazine, Trihalogenmethylgruppen enthaltende Carbonylmethylenheterocyclen, z. B. 2-(p-Trichlormethyl-benzoylmethylen)-3-ethyl-benzthiazolin, Acridinderivate, z. B. 9-Phenyl-acridin, 9-p-Methoxyphenyl-acridin, 9-Acetylamino-acridin, Benz(a)acridin; Phenazinderivate, z. B. 9, 10-Dimethyl-benz(a)phenazin, 10-Methoxy-benz(a)phenazin, Chinoxalinderivate, z. B. 6,4′,4˝-Trimethoxy-2,3-diphenylchinoxalin, 4′,4˝-Dimethoxy-2,3-diphenyl-5-azachinoxalin oder Chinazolinderivate. Die Initiatoren werden allgemein in einer Menge von 0,01 bis 10, vorzugsweise von 0,05 bis 4 Gew.-%, bezogen auf die nicht flüchtigen Bestandteile des Gemisches, eingesetzt.

Das erfindungsgemäße Gemisch enthält im allgemeinen 25 bis 75, bevorzugt 40 bis 65, Gew.-% Bindemittel und 25 bis 75, bevorzugt 35 bis 60, Gew.-% polymerisierbare Verbindungen, bezogen jeweils auf die Gesamtmenge an nicht flüchtigen Bestandteilen.

Das Gemisch kann als übliche weitere Bestandteile Polymerisationsinhibitoren, Wasserstoffdonatoren, Lichtempfindlichkeitsregler, Farbstoffe, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen-und Elektronenstrahlung. Auch Laserstrahlung im sichtbaren und UV-Bereich kann verwendet werden.

Als Schichtträger für mit dem erfindungsgemäßen Gemisch hergestellte Aufzeichnungsmaterialien sind beispielsweise Aluminium, Stahl, Zink, Kupfer, Siebe oder Kunststoffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu bearbeitende Werkstück, z. B. auf Leiterplatten-Basismaterial, aufgebracht werden. Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Folien lassen sich mit in der Trockenresisttechnik üblichen Geräten verarbeiten. In einer handelsüblichen Laminiervorrichtung wird die Deckfolie abgezogen und die Photoresistschicht auf ggf. gebohrtes, verkupfertes Basismaterial laminiert. Die so präparierte Platte wird dann durch eine Vorlage belichtet und nach Abziehen der Trägerfolie in bekannter Weise entwickelt.

Die bildmäßig belichtete oder bestrahlte Schicht kann in bekannter Weise mit den für Schichten auf Basis von Phenolpolymeren bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie ggf. kleinere Anteile organischer Lösungsmittel enthalten. In bestimmten Fällen sind auch Lösungsmittel Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Durch die Erfindung sind Negativschichten zugänglich, die in der Auflösung gegenüber Schichten auf Basis von Carboxylgruppen enthaltenden Bindemitteln deutlich besser sind. Weiterhin zeigen die neuen Schichten im belichteten Zustand eine bessere Lösemittelresistenz. Diese Eigenschaft spielt vor allem bei Anwendungen in Lötstopmasken eine bedeutende Rolle. Die belichteten Resistschablonen sind auch gegenüber aggressiven Verarbeitungslösungen, z. B. Goldbädern, beständig und haben eine gute Entwicklerresistenz. Die erfindungsgemäßen Gemische bilden Trockenresistschichten, deren Scherviskosität im unbelichteten Zustand weniger von der Luftfeuchtigkeit abhängig ist als die von bekannten vergleichbaren Trockenresistmaterialien.

Das erfindungsgemäße Gemisch eignet sich außer für das Trockenresistverfahren auch für andere Anwendungen, bei denen es auf Flexibilität und Zähigkeit einer lichtempfindlichen Schicht ankommt, so z. B. für die Herstellung von Photoresistlösungen, von Druckformen, Reliefbildern, Siebdruckschablonen und Farbprüffolien.

Die folgenden Beispiele erläutern bevorzugte Ausführungsformen des erfindungsgemäßen Gemischs und ihre Anwendung. Wenn nichts anderes angegeben ist, sind Prozentzahlen und Mengenverhältnisse in Gewichtseinheiten zu verstehen. Gewichtsteile (Gt) und Volumteile (Vt) stehen im Verhältnis von g zu cm³.

### Beispiel 1

Es wurden Beschichtungslösungen hergestellt aus jeweils
6 Gt eines Polymerisats aus:
a) p-Hydroxystyrol und Styrol (80:20 mol-%, OH-Zahl: 315),
b) Brenzkatechinmonomethacrylat und 2-Ethyl-hexylmethacrylat (75:25 mol-%, OH-Zahl: 220)
c) Pyrogalll-1-monomethacrylat und 2-Ethyl-hexylmethacrylat (65:35 mol-%, OH-Zahl: 328),
d) Methylmethacrylat, n-Hexylmethacrylat und Methacrylsäure (5:60:35 mol-%, Säurezahl: 190),
5 Gt Trimethylolpropantriacrylat,
0,1 Gt 2-(4-Trichlormethyl-benzoylmethylen)-3-ethyl-benzthiazolin,
0,009 Gt eines blauen Azofarbstoffs, erhalten durch Kuppeln von 2,4-Dinitro-6-chlor-benzoldiazoniumchlorid mit 2-Methoxy-5-acetylamino-N,N-diethylanilin in
14 Gt Butanon und
7 Gt Ethanol
Die Lösungen wurden auf biaxial verstreckte und thermofixierte Polyethylenterephthalatfolien von 25 µm Stärke so aufgeschleudert, daß nach dem Trocknen bei 100° C jeweils ein Schichtgewicht von 45 g/m² erhalten wurde.

Die so hergestellten Trockenresistfolien wurden mit einer handelsüblichen Laminiervorrichtung bei 115° C auf mit 35 µm starker Kupferfolie kaschierte Phenoplast-Schichtstoffplatten laminiert und mittels einer 5-kW-Metallhalogenidlampe im Abstand von 110 cm zwischen Lampe und Vakuumkopierrahmen 20 s belichtet. Als Vorlage diente eine Strichvorlage mit Linienbreiten und Abständen bis herab zu 10 µm.

Nach der Belichtung wurden die Polyesterfolien abgezogen und die Schichten a) bis c) mit 1 %iger Natriumhydroxidlösung, Vergleichsschicht d) mit 1 %iger Natriumcarbonatlösung, in einem Sprühentwicklungsgerät 60 s entwickelt.

Die erreichbare Auflösung betrug bei den Schichten a) bis c) ca. 50 µm, während sich bei Schicht d) maximal 80 µm breite Gräben strukturieren ließen. Auch durch Variation der Belichtungs- bzw. Entwicklungszeit ließ sich der für Schicht d) angegebene Wert nicht verbessern.

Die Flexibilität der gehärteten Resistschichten wurde nach DIN 53 232 geprüft. Mit einem kammartigen Gitterschnittwerkzeug wurden parallele Schnitte von 1 mm Abstand in einer Richtung und in einer zweiten um 90° dazu geänderten Richtung durch die Resistschicht hindurch eingeritzt. Dann wurde ein druckempfindlicher Klebstreifen auf die Schichtoberfläche im Schnittbereich fest aufgedrückt und mit definierter Kraft und Geschwindigkeit abgezogen. Die Flexibilität und Haftung der Schicht wurden danach bewertet, wie die Schnittkanten aussahen und wieviel Prozent der Schnittquadrate vom Schichtträger abgelöst waren. Die Bewertung erfolgte auf einer Skala von Gt 0 bis Gt 4, wobei Gt 0 vollständig glatte, unbeschädigte Schnittkanten und 0 % Ablösung, Gt 4 starke streifenweise Absplitterung entlang der Schnittkanten und mindestens 65 % Ablösung von Schnittquadraten bedeutet.

Während die Resistschichten a) bis c) flexibel waren (Gt 0), war die Vergleichsschicht d) spröde (Gt 4). Die Flexibilität des Resists ist eine wesentliche Eigenschaft, die bei der Verarbeitung und bei einer möglichen Retusche oder Korrektur eine Rolle spielt.

In einem weiteren Versuch wurden wie oben hergestellte und entwickelte Platten 30 s mit Leitungswasser gespült, 30 s in einer 15 %igen Ammoniumperoxodisulfat-Lösung angeätzt, erneut mit Wasser gespült, 30 s in 10 %ige Schwefelsäure getaucht und sodann nacheinander in den folgenden Elektrolytbädern galvanisiert:
1. 60 Minuten in einem Kupferelektrolytbad der Firma Schlötter, Geislingen/Steige, Typ "Glanzkupfer-Bad"
   Stromdichte : 2,5 A/dm²
   Metallaufbau: ca. 30 µm
   Temperatur : Raumtemperatur
2. 15 Minuten in einem Bleizinnbad LA der Firma Schlötter, Geislingen/Steige
   Stromdichte : 2 A/dm²
   Metallaufbau: 15 µm
   Temperatur : Raumtemperatur
Die Platten zeigten keinerlei Unterwanderungen oder Beschädigungen.

### Beispiel 2

Auf 4 Polyesterfolien der im Beispiel 1 angegebenen Beschaffenheit wurden Lösungen folgender Zusammensetzung so aufgeschleudert, daß nach dem Trocknen ein Schichtgewicht von jeweils 30 g/m² erhalten wurde:
5 Gt eines Polymerisats aus:
a) p-Hydroxystyrol und Styrol (80:20 mol-%, OH-Zahl: 315),
b) Brenzkatechinmonomethacrylat und 2-Ethyl-hexylmethacrylat (75:25 mol-%, OH-Zahl: 220), c) Resorcinmonomethacrylat und n-Octylmethacrylat (75:25 mol-%, OH-Zahl: 192),
d) Methylmethacrylat, n-Hexylmethacrylat und Methacrylsäure (5:60:35 mol-%, Säurezahl: 190),
3 Gt des Umsetzungsprodukts aus 1 mol Hexapropylenglykolmonomethacrylat und 1 mol Phenylisocyanat,
0,1 Gt 2-(4-Trichlormethyl-benzoylmethylen)-3-ethyl-benzthiazolin)
0,006 Gt des blauen Azofarbstoffs aus Beispiel 1 und
0,003 Gt des grünen Farbstoffs 1,4-Bis-(4-tert.-butoxy-phenylamino)-5,8-dihydroxy-anthrachinon in
25 Gt Butanon und
5 Gt Ethanol.

Die Materialien wurden wie in Beispiel 1 verarbeitet. In belichtetem Zustand waren die Schichten aus den Lösungen a) bis c) flexibel (Gt 0), während die Vergleichsschicht d) Sprödigkeit aufwies (Gt 2).

Die Entschichtungszeit in 2 %iger Kalilauge bei 50° C wurde durch den Zusatz des monofunktionellen Monomeren auf etwa die Hälfte verkürzt.

### Beispiel 3

Es wurden Beschichtungslösungen hergestellt aus
6 Gt eines Polymerisats aus Pyrogallol-1-monomethacrylat und 2-Ethyl-hexylmethacrylat (65:35 mol-%, OH-Zahl: 328),
x Gt des Umsetzungsprodukts aus Glycidylmethacrylat und 4-Hydroxybenzoesäure,
y Gt Trimethylolpropantriacrylat,
0,05 Gt 9-Phenyl-acridin,
0,006 Gt des blauen Azofarbstoffs aus Beispiel 1 und
0,024 Gt des grünen Farbstoffs aus Beispiel 2 in
30 Gt Butanon und
6 Gt Ethanol.

Die Mengenanteile der Monomeren in den einzelnen Gemischen waren wie folgt:
a) x=0,5; y=4,5 b) x=1,1; y=3,9 c) x=2; y=3
Die Materialien wurden wie in Beispiel 1 verarbeitet. In belichtetem Zustand waren alle Resistschichten flexibel. Zum Entschichten in 2 %iger Kalilauge bei 50° C wurden die folgenden Zeiten (Sekunden) benötigt:
a) 55 - 70 b) 45 - 55 c) 30 - 40
Die Abhängigkeit der Entschichtungszeit vom Mengenanteil an monofunktionellem Monomeren ist deutlich erkennbar.

### Beispiel 4

Es wurde eine Beschichtungslösung hergestellt aus
23 Gt eines Polymerisats aus Brenzkatechinmonomethacrylat und 2-Ethyl-hexylmethacrylat (75:25 mol-%, OH-Zahl: 240),
7 Gt 2,2-Bis-(4-glycidyloxy-phenyl)propan (0,00527 mol Epoxygruppen je g),
5,5 Gt Trimethylolpropantrimethacrylat,
0,4 Gt 2-(4-Trichlormethyl-benzoylmethylen)-3-ethyl-benzthiazolin,
0,35 Gt des grünen Farbstoffs aus Beispiel 2 und
0,032 Gt Diazabicyclo[2.2.2]octan in
36 Gt 3-Methoxy-butanol-1,
3 Gt Ethanol,
5 Gt Butanon.

Die Verarbeitung erfolgte wie in Beispiel 1 unter zusätzlicher Nachhärtung von 30 Minuten bei 135° C im Trockenschrank. Die Schicht wies gute Haftfestigkeit auf. Nach 24 Stunden Behandlung mit Ethanol wurde kein Schichtabtrag festgestellt. Schichten dieser Art eignen sich daher für die Herstellung von Lötstopmasken.

### Beispiel 5

Es wurde eine Beschichtungslösung hergestellt aus
6 Gt eines Polymerisats aus Brenzkatechinmonomethacrylat und 2-Ethyl-hexylmethacrylat (75 : 25 mol-%, OH-Zahl 315),
5 Gt einer der unten angegebenen polymerisierbaren Verbindungen,
0,5 Gt des blauen Azofarbstoffs aus Beispiel 1 und
0,09 Gt 2-(4-Trichlormethyl-benzoylmethylen)-3-ethyl-benzthiazolin in
20 Gt Ethanol.

Als polymerisierbare Verbindungen wurden im einzelnen eingesetzt:
a) Hexandioldimethacrylat,
b) Triethylenglykoldimethacrylat,
c) Trimethylolpropantriacrylat,
d) Trimethylolpropantrimethacrylat,
e) Tripropylenglykoldiacrylat,
f) Hexandioldiacrylat.

Zum Vergleich wurden Beschichtungslösungen g, h, i, j, k, l hergestellt, die bei sonst gleicher Zusammensetzung wie bei a bis f statt des angegebenen Polymeren die gleiche Menge eines Polymerisats aus Methylmethacrylat, n-Hexylmethacrylat und Methacrylsäure (5:60:35 mol-%, Säurezahl: 190) enthielten.

Die Materialien wurden wie in Beispiel 1 verarbeitet. Während die Resistschichten a bis f flexibel waren (Gt 0), waren die Vergleichsschichten g bis l spröde (Gt 4).

### Beispiel 6

Es wurden Beschichtungslösungen der folgenden Zusammensetzung hergestellt:
a) 6 Gt eines Polymerisats aus Pyrogallol-1-monomethacrylat und Octylmethacrylat (80:20 mol-%),
   5 Gt des Umsetzungsprodukts aus 1 mol Hexaethylenglykol und 2 mol Isocyanatooctylmethacrylat,
   0,1 Gt 2-(4-Trichlormethyl-benzoylmethylen)-3-ethyl-benzthiazolin,
   0,006 Gt des blauen Azofarbstoffs aus Beispiel 1 und
   0,003 Gt des grünen Farbstoffs aus Beispiel 2 in
   20 Gt Butanon und
   6 Gt Ethanol
b) gleiche Lösung wie unter a, worin jedoch das Polymerisat durch die gleiche Menge eines Polymerisats aus Methylmethacrylat, n-Hexylmethacrylat und Methacrylsäure (5:60:35 mol-%) ersetzt war.

Die Lösungen wurden auf Polyesterfolien des in Beispiel 1 angegebenen Typs aufgeschleudert und getrocknet; das Schichtgewicht betrug jeweils 45 g/m². Die Trockenresistmaterialien wurden dann in einem handelsüblichen Laminator bei 115° C auf kupferkaschierte Isolierstoffplatten laminiert. Die Haftung der unbelichteten Schichten wurde nach dem in Beispiel 1 beschriebenen Gitterschnittest geprüft. Die folgende Tabelle zeigt die Ergebnisse:

| | a | b |
|---|---|---|
| Haftung | Gt 0 | > Gt 3 |

### Beispiel 7

Es wurde eine Beschichtungslösung hergestellt aus
6 Gt eines Polymerisats aus p-Hydroxystyrol und Styrol (80:20 mol-%, OH-Zahl: 315),
5 Gt Trimethylolpropantriacrylat,
0,2 Gt 2-(4-Trichlormethyl-benzoylmethylen)-3-ethyl-benzthiazolin und
0,03 Gt des blauen Azofarbstoffs gemäß Beispiel 1 in 35 Gt Butanon.

Die Lösung wurde auf elektrochemisch aufgerauhtes und anodisiertes Aluminium mit einer Oxidschicht von 2 g/m², das mit einer wäßrigen Lösung von Polyvinylphosphonsäure vorbehandelt war, so aufgeschleudert, daß ein Trockengewicht von 3,5 g/m² erhalten wurde. Anschließend wurde die Platte mit einer Polyvinylalkohol-Deckschicht von 4 g/m² versehen. Die Druckplatte wurde halbiert, und beide Hälften wurden mittels einer 5-kW-Metallhalogenidlampe unter einem 13-stufigen Halbtonkeil sowie unter einem 60er und 120er Rasterstufenkeil 2 s belichtet. Eine Hälfte wurde zusätzlich nach dem Belichten 5 Minuten bei 100° C im Umlufttrockenschrank erhitzt.

Anschließend wurde mit einem Entwickler folgender Zusammensetzung entwickelt:
3,0 Gt Natriummetasilikat x 9 H₂O,
0,03 Gt nichtionogenes Netzmittel (Kokosfettalkohol-Polyoxyethylenether mit ca. 8 Oxyethyleneinheiten) und
0,003 Gt Antischaummittel in
96,967 Gt vollentsalztem Wasser.

Ohne Nacherhitzung wurden sechs, mit Nacherhitzung acht vollvernetzte Keilstufen erhalten.

## Patentansprüche

1. Durch Strahlung polymerisierbares Gemisch, das als wesentliche Bestandteile
a) ein in Wasser unlösliches, in wäßrig-alkalischen Lösungen lösliches polymeres Bindemittel,
b) eine radikalisch polymerisierbare Verbindung mit mindestens einer endständigen ethylenischen Doppelbindung und einem Siedepunkt oberhalb 100° C bei Normaldruck und
c) eine Verbindung oder eine Verbindungskombination enthält, die unter Einwirkung von aktinischer Strahlung die Polymerisation der Verbindung (b) zu initiieren vermag,
dadurch gekennzeichnet, daß das Bindemittel ein Polymeres mit wiederkehrenden Einheiten der allgemeinen Formel I 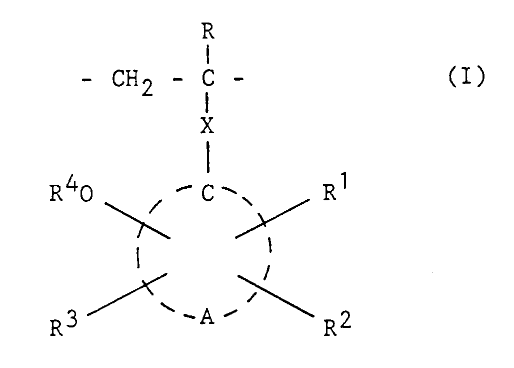 ist, worin
R ein Wasserstoff- oder Halogenatom, eine Cyanogruppe oder eine Alkylgruppe mit 1-4 Kohlenstoffatomen ist,
R¹, R² und R³ gleich oder verschieden sind und Wasserstoff-oder Halogenatome, Alkyl-, Alkoxy-, Alkoxycarbonyl-, Acyl-, Aryloxy-, Aroyl-, Hydroxy-oder Aralkylgruppen bedeuten,
R⁴ ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I R⁴ ein Wasserstoffatom ist,
X eine kovalente Bindung, ein Sauerstoffatom oder eine der Gruppen COO, CONR⁸, COOCH₂CHOHCH₂OCO, COOCH₂CH₂O und COOCH₂CH₂OCO ist, worin R⁸ ein Wasserstoffatom, eine Alkyl- oder Arylgruppe bedeutet, und
A die zur Vervollständigung eines ein- oder zweikernigen carbo- oder heterocyclischen aromatischen Ringsystems erforderlichen Atome bedeutet.

2. Strahlungsempfindliches Gemisch nach Anspruch 1, dadurch gekennzeichnet, daß das Bindemittel zusätzlich Einheiten der allgemeinen Formel II 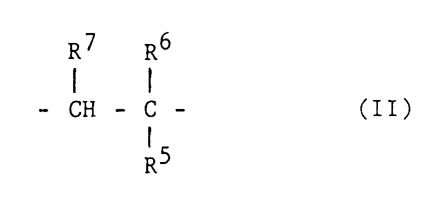 enthält, worin
R⁵ ein Wasserstoff- oder Halogenatom oder eine Alkylgruppe,
R⁶ eine Alkyl-, Alkoxy-, Alkoxycarbonyl-, Acyl-, Acyloxy-, Aryl-, Formyl-, Cyano-, Carboxyl-, Hydroxy- oder Aminocarbonylgruppe und
R⁷ ein Wasserstoffatom oder eine Carboxylgruppe bedeutet, die mit R⁶, wenn dieses eine Carboxylgruppe ist, zu einem Säureanhydrid verbunden sein kann.

3. Strahlungsempfindliches Gemisch nach Anspruch 1, dadurch gekennzeichnet, daß das Bindemittel ein Molekulargewicht M̅ₙ von 1000 bis 200.000 hat.

4. Durch Strahlung polymerisierbares Gemisch nach Anspruch 1, dadurch gekennzeichnet, daß das Polymere je Einheit der Formel I 1 oder 2 Hydroxygruppen enthält.

5. Durch Strahlung polymerisierbares Gemisch nach Anspruch 1, dadurch gekennzeichnet, daß das Polymere 20 bis 100 mol-% Einheiten der Formel I enthält.

6. Durch Strahlung polymerisierbares Gemisch nach Anspruch 1, dadurch gekennzeichnet, daß die polymerisierbare Verbindung ein Ester der Acryl- oder Methacrylsäure mit einem aliphatischen Alkohol ist.

7. Durch Strahlung polymerisierbares Aufzeichnungsmaterial mit einem flexiblen, transparenten temporären Schichtträger und einer übertragbaren thermoplastischen, durch Strahlung polymerisierbaren Photoresistschicht, die als wesentliche Bestandteile
a) ein in Wasser unlösliches, in wäßrig-alkalischen Lösungen lösliches polymeres Bindemittel,
b) eine radikalisch polymerisierbare Verbindung mit mindestens einer endständigen ethylenischen Doppelbindung und einem Siedepunkt oberhalb 100° C bei Normaldruck und
c) eine Verbindung oder eine Verbindungskombination enthält, die unter Einwirkung von aktinischer Strahlung die Polymerisation der Verbindung (b) zu initiieren vermag,
und gegebenenfalls einem Deckblatt auf der freien Seite der Photoresistschicht, das an dieser Schicht weniger stark haftet als der temporäre Schichtträger, dadurch gekennzeichnet, daß das Bindemittel ein Polymeres mit wiederkehrenden Einheiten der allgemeinen Formel I 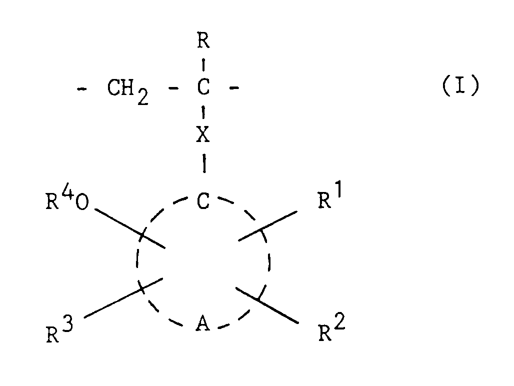 ist, worin
R ein Wasserstoff- oder Halogenatom, eine Cyanogruppe oder eine Alkylgruppe mit 1-4 Kohlenstoffatomen ist,
R¹, R² und R³ gleich oder verschieden sind und Wasserstoff-oder Halogenatome, Alkyl-, Alkoxy-, Alkoxycarbonyl-, Acyl-, Aryloxy-, Aroyl-, Hydroxy-oder Aralkylgruppen bedeuten,
R⁴ ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I R⁴ ein Wasserstoffatom ist,
X eine kovalente Bindung, ein Sauerstoffatom oder eine der Gruppen COO, CONR⁸, COOCH₂CHOHCH₂OCO, COOCH₂CH₂O und COOCH₂CH₂OCO ist, worin R⁸ ein Wasserstoffatom, eine Alkyl- oder Arylgruppe bedeutet, und
A die zur Vervollständigung eines ein- oder zweikernigen carbo- oder heterocyclischen aromatischen Ringsystems erforderlichen Atome bedeutet.

8. Verfahren zur Herstellung von Reliefaufzeichnungen, bei dem man eine trockene, feste, thermoplastische, durch Strahlung polymerisierbare Photoresistschicht, die als wesentliche Bestandteile
a) ein in Wasser unlösliches, in wäßrig-alkalischen Lösungen lösliches polymeres Bindemittel,
b) eine radikalisch polymerisierbare Verbindung mit mindestens einer endständigen ethylenischen Doppelbindung und einem Siedepunkt oberhalb 100° C bei Normaldruck und
c) eine Verbindung oder eine Verbindungskombination enthält, die unter Einwirkung von aktinischer Strahlung die Polymerisation der Verbindung (b) zu initiieren vermag,
und die sich auf einem flexiblen transparenten temporären Schichtträger befindet, unter Druck und Erwärmen auf einen endgültigen Schichtträger laminiert, bildmäßig bestrahlt, den temporären Schichtträger abzieht und die unbestrahlten Schichtbereiche mit einer wäßrig-alkalischen Lösung auswäscht, dadurch gekennzeichnet, daß die Photoresistschicht als Bindemittel ein Polymeres mit wiederkehrenden Einheiten der allgemeinen Formel I gemäß Anspruch 1 enthält.

## Claims

1. A radiation-polymerizable mixture which contains as essential constituents
a) a polymeric binder which is insoluble in water yet soluble in aqueous alkali,
b) a free radical polymerizable compound having at least one terminal ethylenic double bond and a boiling point above 100°C under atmospheric pressure and
c) a compound, or a combination of compounds, capable of initiating the polymerization of compound (b) under the action of actinic radiation,
wherein the binder is a polymer which includes repeat units of the general formula I 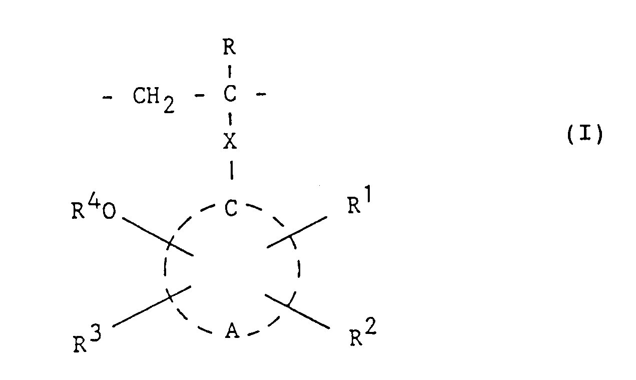 where
R is hydrogen, halogen, cyano or alkyl of 1-4 carbon atoms,
R¹, R² and R³ are identical or different and are each hydrogen, halogen, alkyl, alkoxy, alkoxycarbonyl, acyl, aryloxy, aroyl, hydroxyl or aralkyl,
R⁴ is hydrogen or a divalent organic group linked intermolecularly or intramolecularly to a further unit of the formula I, on average R⁴ being hydrogen in at least 80 mol% of the units of the formula I,
X is a covalent bond, oxygen or one of the groups COO, CONR⁸, COOCH₂CHOHCH₂OCO, COOCH₂CH₂O and COOCH₂CH₂OCO, where R⁸ is hydrogen, alkyl or aryl, and
A denotes the atoms required to complete a monocyclic or dicyclic carbocyclic or heterocyclic aromatic ring system.

2. A radiation-sensitive mixture as claimed in claim 1, wherein the binder additionally contains units of the general formula II 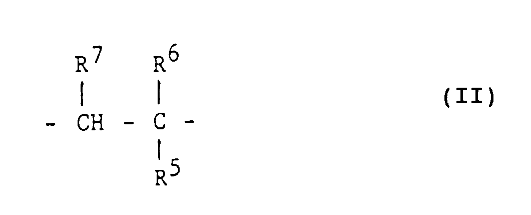 where
R⁵ is hydrogen, halogen or alkyl,
R⁶ is alkyl, alkoxy, alkoxycarbonyl, acyl, acyloxy, aryl, formyl, cyano, carboxyl, hydroxyl or aminocarbonyl and
R⁷ is hydrogen or a carboxyl group which may be bonded to a carboxyl R⁶ to form an anhydride.

3. A radiation-sensitive mixture as claimed in claim 1, wherein the binder has a molecular weight Mₙ of 1000 to 200,000.

4. A radiation-polymerizable mixture as claimed in claim 1, wherein the polymer contains 1 or 2 hydroxyl groups per unit of the formula I.

5. A radiation-polymerizable mixture as claimed in claim 1, wherein the polymer contains 20 to 100 mol% of units of the formula I.

6. A radiation-polymerizable mixture as claimed in claim 1, wherein the polymerizable compound is an ester of acrylic or methacrylic acid with an aliphatic alcohol.

7. A radiation- polymerizable recording material comprising a flexible, transparent temporary support and a transferable, thermoplastic, radiation-polymerizable photoresist layer which contains as essential constituents
a) a polymeric binder which is insoluble in water yet soluble in aqueous alkali,
b) a free radical polymerizable compound having at least one terminal ethylenic double bond and a boiling point above 100°C under atmospheric pressure and
c) a compound, or a combination of compounds, capable of initiating the polymerization of compound (b) under the action of actinic radiation,
with or without a cover sheet, on the open side of the photoresist layer, which is less adherent to this layer than the temporary support, wherein the binder is a polymer which includes repeat units of the general formula I 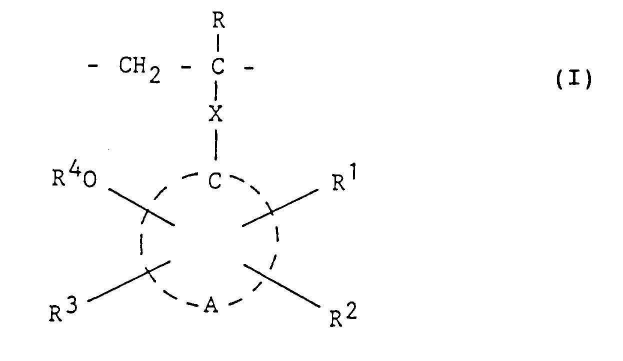 where
R is hydrogen, halogen, cyano or alkyl of 1-4 carbon atoms,
R¹, R² and R³ are identical or different and are each hydrogen, halogen, alkyl, alkoxy, alkoxycarbonyl, acyl, aryloxy, aroyl, hydroxyl or aralkyl,
R⁴ is hydrogen or a divalent organic group linked intermolecularly or intramolecularly to a further unit of the formula I, on average R⁴ being hydrogen in at least 80 mol% of the units of the formula I,
X is a covalent bond, oxygen or one of the groups COO, CONR⁸, COOCH₂CHOHCH₂OCO, COOCH₂CH₂O and COOCH₂CH₂OCO, where R⁸ is hydrogen, alkyl or aryl, and
A denotes the atoms required to complete a monocyclic or dicyclic carbocyclic or heterocyclic aromatic ring system.

8. A process for preparing relief recordings by laminating a dry, solid, thermoplastic, radiation-polymerizable photoresist layer which contains as essential constituents
a) a polymeric binder which is insoluble in water yet soluble in aqueous alkali,
b) a free radical polymerizable compound having at least one terminal ethylenic double bond and a boiling point above 100°C under atmospheric pressure and
c) a compound, or a combination of compounds, capable of initiating the polymerization of compound (b) under the action of actinic radiation,
and is present on a flexible transparent temporary support onto a final support by employing pressure and heat, subjecting it to imagewise exposure, peeling off the temporary support and washing the unexposed areas of the layer with an aqueous alkali, wherein the photoresist layer contains as a binder a polymer based on repeat units of the general formula I as set forth in claim 1.

## Revendications

1. Composition polymérisable par irradiation, qui contient, en tant que composants essentiels,
a) un liant polymère insoluble dans l'eau, soluble dans des solutions aqueuses-alcalines,
b) un composé polymérisable par polymérisation radicalaire, comportant au moins une double liaison éthylénique terminale et ayant un point d'ébullition supérieur à 100°C sous la pression normale, et
c) un composé ou une association de composés permettant d'amorcer la polymérisation du composé b) sous l'effet d'un rayonnement actinique,
caractérisée en ce que le liant est un polymère comportant des motifs répétitifs de formule générale I 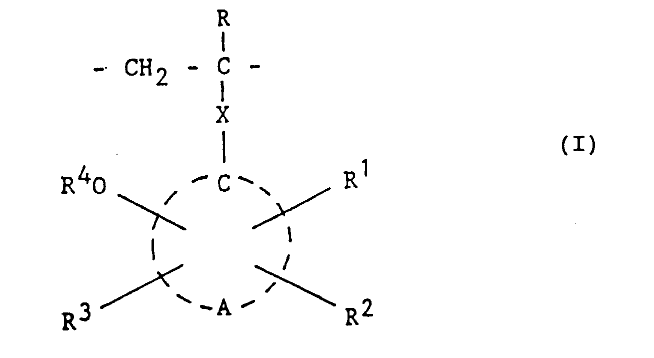 dans laquelle
R représente un atome d'hydrogène ou d'halogène, un groupe cyano ou un groupe alkyle ayant de 1 à 4 atomes de carbone,
R¹, R² et R³ sont identiques ou différents et représentent des atomes d'hydrogène ou d'halogène ou des groupes alkyle, alcoxy, alcoxycarbonyle, acyle, aryloxy, aroyle, hydroxy ou aralkyle,
R⁴ représente un atome d'hydrogène ou un groupe organique divalent qui est lié par liaison inter- ou intramoléculaire à un autre motif de formule I, en moyenne R⁴ étant un atome d'hydrogène dans au moins 80 % en moles des motifs de formule I,
X est une liaison covalente, un atome d'oxygène ou l'un des groupes COO, CONR⁸, COOCH₂CHOHCH₂OCO, COOCH₂CH₂O et COOCH₂CH₂OCO, R⁸ représentant un atome d'hydrogène ou un groupe alkyle ou aryle, et
A représente les atomes nécessaires pour compléter un système cyclique aromatique carbo- ou hétérocyclique mono-ou bicyclique.

2. Composition sensible aux radiations selon la revendication 1, caractérisée en ce que le liant contient en outre des motifs de formule générale II 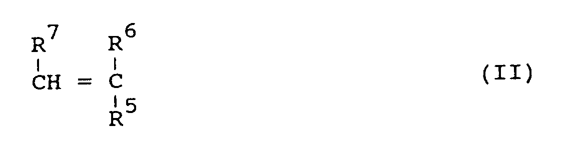 dans laquelle
R⁵ est un atome d'hydrogène ou d'halogène ou un groupe alkyle,
R⁶ est un groupe alkyle, alcoxy, alkyloxycarbonyle, acyle, acyloxy, aryle, formyle, cyano, carboxy, hydroxy ou aminocarbonyle, et
R⁷ est un atome d'hydrogène ou un groupe carboxy qui peut être lié à R⁶, lorsque celui-ci est un groupe carboxy, pour donner un anhydride d'acide.

3. Composition sensible aux radiations selon la revendication 1, caractérisée en ce que le liant a une masse moléculaire M̅ₙ allant de 1 000 à 200 000.

4. Composition polymérisable par irradiation selon la revendication 1, caractérisée en ce que le polymère contient 1 ou 2 groupes hydroxy par motif de formule I.

5. Composition polymérisable par irradiation selon la revendication 1, caractérisée en ce que le polymère contient de 20 à 100 % en moles de motifs de formule I.

6. Composition polymérisable par irradiation selon la revendication 1, caractérisée en ce que le composé polymérisable est un ester de l'acide acrylique ou méthacrylique avec un alcool aliphatique.

7. Matériau de reprographie polymérisable par irradiation, comportant un support de couche temporaire flexible, transparent, et une couche de photorésist thermoplastique transférable, polymérisable par irradiation, qui contient, en tant que composants essentiels
a) un liant polymère insoluble dans l'eau, soluble dans des solutions aqueuses-alcalines,
b) un composé polymérisable par polymérisation radicalaire, comportant au moins une double liaison éthylénique terminale et ayant un point d'ébullition supérieur à 100°C sous la pression normale, et
c) un composé ou une association de composés permettant d'amorcer la polymérisation du composé b) sous l'effet d'un rayonnement actinique,
et éventuellement une feuille de recouvrement sur le côté libre de la couche de photorésist, qui adhère moins fortement à cette couche que le support de couche temporaire, caractérisé en ce que le liant est un polymère à motifs répétitifs de formule générale I 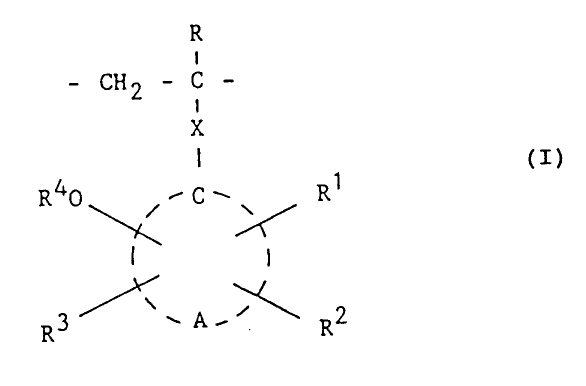 dans laquelle
R représente un atome d'hydrogène ou d'halogène, un groupe cyano ou un groupe alkyle ayant de 1 à 4 atomes de carbone,
R¹, R² et R³ sont identiques ou différents et représentent des atomes d'hydrogène ou d'halogène ou des groupes alkyle, alcoxy, alcoxycarbonyle, acyle, aryloxy, aroyle, hydroxy ou aralkyle,
R⁴ représente un atome d'hydrogène ou un groupe organique divalent qui est lié par liaison inter- ou intramoléculaire à un autre motif de formule I, en moyenne R⁴ étant un atome d'hydrogène dans au moins 80 % en moles des motifs de formule I,
X est une liaison covalente, un atome d'oxygène ou l'un des groupes COO, CONR⁸, COOCH₂CHOHCH₂OCO, COOCH₂CH₂O et COOCH₂CH₂OCO, R⁸ représentant un atome d'hydrogène ou un groupe alkyle ou aryle, et
A représente les atomes nécessaires pour compléter un système cyclique aromatique carbo- ou hétérocyclique mono-ou bicyclique.

8. Procédé pour l'obtention de reproductions en relief, dans lequel on applique par laminage sur un support de couche final, sous pression et en chauffant, une couche de photorésist sèche, solide, thermoplastique, polymérisable par irradiation, qui contient, en tant que composants essentiels
a) un liant polymère insoluble dans l'eau, soluble dans des solutions aqueuses-alcalines,
b) un composé polymérisable par polymérisation radicalaire, comportant au moins une double liaison éthylénique terminale et ayant un point d'ébullition supérieur à 100°C sous la pression normale, et
c) un composé ou une association de composés permettant d'amorcer la polymérisation du composé b) sous l'effet d'un rayonnement actinique,
et se trouve sur un support de couche temporaire flexible, transparent, on l'irradie selon l'image, on enlève le support de couche temporaire et on élimine par lavage avec une solution aqueuse-alcaline les zones non irradiées de la couche, caractérisé en ce que la couche de photorésist contient en tant que liant un polymère à motifs répétitifs de formule générale I selon la revendication 1.
